# EUROPEAN PATENT APPLICATION

(11) **EP 4 219 223 A1**
(43) Date of publication of application: **02.08.2023**
(21) Application number: 22154536.1
(22) Date of filing: 01.02.2022
(51) Int. Cl.: B60L 53/16, B60L 53/302, H01R 13/00, H02J 1/00, H01B 7/42

(54) **A CHARGING PLUG CONNECTOR**

(71) Applicant: ABB E-mobility B.V., 2629 JG Delft (NL)
(72) Inventor: KAUFMANN, Lilian, 5413 Birmenstorf (CH); RAAIJMAKERS, Stefan, 2613 WN Delft (NL); GARCIA-FERRE, Francisco, 5400 Baden (CH); KHEIRI, Pedram, 5212 Hausen (CH); ZOON, Wiebe, 2623 NM Delft (NL); UGUR, Ali, 2545 XP Den Haag (NL)
(74) Representative: Maiwald GmbH

(57) **Abstract**

A charging plug connector (100) for transfer of electrical energy to a corresponding connecting device (210) is described, with:
at least one power contact component (122), including:
a first connecting region (120) for galvanic connection to a corresponding connection region of the connecting device (210);
a second connecting region (124) electrically coupled to a charging cable (130);
wherein the power contact component (122) is configured to provide electrical energy from the charging cable (130) to the first connecting region (120);
a charging plug housing (107) covering the power contact component (122); and
a compressed air connector (110), which is mechanically coupled to the charging plug housing (107), wherein the charging plug connector (100) is configured to guide a compressed air stream, which is provided to the compressed air connector (110), to the power contact component (122) for cooling it.

## Description

### Background

Charging connectors for electrical vehicles (EV) are facing an increased demand to handle higher voltages and higher currents, e.g. the EV charging technology should be capable of delivering up to 3 kA and 1,5 kV DC. The most likely short-term scenario is a configuration for 1 MW (1 kA;1 kV DC). In the mid-term, the target will be 3 MW (2 kA; 1,5 kV DC). That means, there is a demand for cable and connectors for higher power charging of heavy electric vehicles such as trucks or aircraft.

Previous work focused primarily on currents of the order of 350 A, at which the connector losses, without cable losses, were of the order of low tens of watts. Current targets, e.g. for fast charging of trucks aim at currents of the order of 1000 A, with corresponding heating losses in the connector of the order of low to high hundreds of Watt.

EV charging connectors, e.g. CCS (connectors combined charging system) - connectors, may bring up quality and safety issues, resulting in mechanical failures of connectors and incidents related to the electrical design. The latter were also influenced by ingress of water into the connectors following mechanical damage of plastic parts. Improvements in respect to quality and safety of EV charging connectors including suitability for high power are required.

### Description

During operation of the EV charging connectors typically forced liquid cooling is used to cool both the cable and the contacts. Basically, fresh coolant is brought in thermal contact to a chamber at the base of the DC contacts, and is flowing back in thermal contact to the power cables for cooling. This way the coolant is at its lowest temperature when in contact with the base of the DC contact elements.

One of the key features of the currently pursuit mating interface is that the contact elements itself are flat. The car inlet has male contacts, i.e. flat copper plates, whereas the EV connector interface has female contacts.

However, the fact that the contacts are flat brings along thermal management issues, as it is difficult to evacuate the heat losses generated at the contact tips. Indeed, the heat transfer mechanism in this arrangement is exclusively thermal conduction of copper material of which the contacts are composed.

Accordingly, the present invention is directed to a charging plug connector and to a system for transfer of electrical energy from a charging plug connector to a corresponding connecting device.

Advantageous modifications of the invention are stated in the dependent claims. All combinations of at least two of the features disclosed in the description, the claims and the figures fall within the scope of the invention. In order to avoid repetition, features disclosed in accordance with the method shall also apply and be claimable in accordance with mentioned systems.

In this entire description of the invention, some features are provided with counting words to improve readability or to make the assignment more clear, but this does not imply the presence of certain features.

To achieve these and other advantages and in accordance with the purpose of the invention, as embodied and broadly described herein, there is provided a charging plug connector for transfer of electrical energy to a corresponding connecting device. The charging plug connector includes at least one power contact component, with a first connecting region for galvanic connection to a corresponding connection region of the connecting device; and a second connecting region electrically coupled to a charging cable for providing of electrical energy to the power contact component. The power contact component is configured to provide electrical energy from the charging cable to the first connecting region.

The charging plug connector includes a charging plug housing, which covers at least the power contact component, and a compressed air connector, which is mechanically coupled to the charging plug housing. The charging plug connector is configured to guide a compressed air stream, which is provided to the compressed air connector, to the power contact component for cooling it.

According to an aspect, the compressed air connector can be mechanically coupled, preferably additionally fluidic coupled, and located directly at the housing of the charging plug connector or the compressed air connector can be mechanically coupled, preferably additionally fluidic coupled, and located at the charging cable. If the compressed air connector is located at the charging cable, a fluidic coupling with the housing of the charging plug connector is thermally insulated from the electric charging cable, to reduce heat exchange between the compressed air stream and the electric charging cable. Using other words, the goal is to cool the power contact component directly using the compressed air stream having a minimal temperature for improved heat transfer.

According to an aspect, a compressed air supply hose, which can be fluidly coupled to the compressed air connector, can be partially attached to the electric charging cable, and can be thermally decoupled from the losses of the copper wire.

The compressed air stream can be generated by using a compressor, which is usually filling a tank and when used the tank supplies the air. The pressure inside the tank can be, for example, 6 to 7 bar. For blowing air through relatively small channels of the power contact component with quite high speed, even small overpressure of the order of 0.1 bar can be sufficient and is depending on the size of the channels, but typically below 2 bars, because above such an overpressure the air can expand to supersonic speeds.

According to an aspect, additionally safety guards may be implemented at the charging plug connector, preferably if an amount and/or a temperature of the compressed air stream exhausting out of the charging plug connector and/or the housing of the charging plug connector is uncomfortable for an operator and/or may present safety risks. Examples for such safety guards can be a means and/or a device for guiding the exhausted air into the environment, preferably into a direction opposite to an operator of the charging plug connector and/or for guiding the exhausted air stream a sufficient distance, preferably for cooling down the air stream. Additionally or alternatively such a safety guard can include a temperature measurement device and/or an air flow measurement device, which can preferably be coupled to the alarm device for warning and/or alarming an operator, particularly by acoustic signals and/or optical signals.

Additional safety safeguards may be implemented at the charging plug connector, for example optical reminders to connect the air plug with the air hose to provide compressed air stream.

Additionally or alternatively, preferably simple, added control and safety measures arranged at and/or coupled to the charging plug connector can ensure that the charging current only "switches on" for providing electrical energy, if sufficient air pressure and air flow are passing through the charging plug connector, preferably this can be in addition to standard over-temperature control measures.

According to an aspect, the compressed air stream can be used for mechanical action, preferably to prevent disconnecting the charging plug connector with compressed air stream, for example by locking the charging plug connector with a compressed air hose at the compressed air connector and/or by locking the charging plug connector to the corresponding connecting device. Advantageously, such a locking can be used in case of heavy and hard to handle connectors for high currents.

Advantageously, the compressed air can be guided within the charging plug connector, preferably by guiding structures and/or cooling-holes and/or cooling-rips and/or fluid-channels and/or a distribution device, to take up heat, which is generated inside of the charging plug connector, for cooling the charging plug connector.

Advantageously, compressed air is widely available, alternatively a standard air compressor can be included in a station for charging electrical vehicles. Typically, standard compressed air pressures of a few bar with a typical flow rate is sufficient for a significant cooling effect of the charging plug connector. The additional components, compressor, air hose, compressed air plugs are standard, easily replaceable, robust and cheap. Compressed air is commonly used in connection to servicing and maintenance of vehicles, and the equipment is familiar to most professional drivers and present at most current gasoline stations, e.g. from tire filling.

Because of the compressed air connector located at the charging plug housing the compressed air stream enters advantageously the charging plug connector at a minimal temperature, because it cannot take up heat of the electrical cabling for charging, opposite to coolants passing the cable.

Alternatively or additionally the compressed air can be cooled before entering the charging plug connector.

A further advantage of the described charging plug connector is that pressure losses of the compressed air is significantly reduced, as no compressed air flow needs to pass a long tubing, which is aligned with the charging cable.

Because the compressed air is dielectric and benign, advantagesly, the compressed air stream can exhaust the charging plug connector freely.

The described charging plug connector can achieve a dramatic improvement of the quality and safety of the thermal management for charging electrical vehicles, having reduced costs and an improvement of the performance.

According to an aspect, the charging plug connector can be configured and/or designed in such a way that an air flow of the compressed air stream is provided by the air hose, in addition the compressed air stream can recirculate a surrounding of the first connecting region and/or recirculate a surrounding of the corresponding connection region of the connecting device and/or recirculate a surrounding of an electrical vehicle inlet comprising the corresponding connecting device, before exhausting out of an entire connector system comprising the charging plug connector and the corresponding connecting device.

Using other words that means, that the electrical vehicle inlet can be additionally cooled by the compressed air stream.

According to an aspect, the charging plug connector and/or the charging cable, which includes means for providing cable coolant, can be configured, e.g. using air stream channels and/or guiding plates, to inter-cool partially the cable coolant, preferably at a site which is upstream of a return path of the cable coolant.

According to an aspect, the first connecting region comprises a clip spring for mechanically and electrically coupling of the first connecting region of the charging plug connector to the corresponding connection region of the connecting device for transfer of electrical energy.

Because the corresponding connection region for galvanic connection with the charging plug connector is typically configured as a male part, i.e. flat copper plates, of the corresponding charging plug connector and connecting device, the clip spring can advantageously provide the female part of such a connector.

According to an aspect, the power contact component comprises cooling-holes for increasing a heat transfer from the power contact component to the compressed air stream.

According to an aspect, the power contact component comprises cooling-ribs for increasing a heat transfer from the power contact component to the compressed air stream.

According to an aspect, the power contact component comprises fluid-channels for increasing a heat transfer from the power contact component to the compressed air stream.

Advantageously, air stream guiding structures for the power contact component, as cooling-holes and/or cooling-ribs and/or fluid-channels can improve a heat exchange between the compressed air stream and the power contact component, for instance, because the surface for heat exchange is increased. Alternatively or additionally, the air stream guiding structures can be formed and distributed at and/or within the power contact component to take up heat from the power contact component, where the temperature is high to increase the thermal contact and a heat transfer of the power contact component with the common compressed air stream.

According to an aspect, the charging plug connector, can comprise a distribution device for distributing the compressed air stream provided by the compressed air connector to the cooling-holes and/or calling-ribs and/or fluid-channels of the power contact component.

The distribution device can be configured by channels and cavities to improve the heat transfer between the power contact component and the compressed air stream according to a temperature profile of the power contact component.

According to an aspect, the distribution device can be configured to provide at least a part of the compressed air stream to the second connecting region and/or to the corresponding connecting device and/or to the surrounding of the first connecting region and/or the surrounding of the second connecting region.

According to an aspect, the charging plug housing comprises an outlet section for releasing the compressed air stream to an environment of the charging plug connector, downstream of the compressed air connector.

As described above, such an outlet section can direct the exhausting air stream opposite to an operator of the charging plug connector to improve safety and convenience. Alternatively or additionally the charging plug connector can be configured to have a plurality of outlet sections.

According to an aspect, the outlet section of the charging plug housing is configured to release the compressed air stream in a direction away from a handle area of the charging plug connector to increase application safety of the charging plug connector.

According to an aspect, the charging plug housing comprises a sub-housing covering the power contact component inside of the charging plug housing, wherein the sub-housing is configured to guide the compressed air stream to the power contact component for increasing the heat transfer from the power contact component to the compressed air stream.

Using other words, such a sub-housing can guide the compressed air stream to improve heat transfer between parts of the charging plug connector and/or the corresponding connecting device and the compressed air stream.

According to an aspect, the charging plug housing and a housing of the corresponding connecting device is configured, by compressed air stream guiding structures of the charging plug housing and/or by compressed air stream guiding structures of the corresponding connecting device, to guide the compressed air stream, provided by the compressed air connector, to the corresponding connecting region of the corresponding connection device.

Advantageously, by means of the compressed air stream guiding structures the compressed air stream can also take up heat of the corresponding connecting device, to cool the corresponding connecting device.

According to an aspect, the air stream guiding structures of the charging plug housing and/or the air stream guiding structures of the housing of the corresponding connecting device is configured to release the compressed air stream at the outlet section of the charging plug connector.

This can improve the comfort and safety of using the charging plug connector.

According to an aspect, the charging plug connector can comprise a temperature sensor for determining the temperature of the released compressed air stream at the outlet section of the charging plug connector to increase application safety.

The temperature sensor can improve the safety for using the charging plug connector, particularly if the temperature sensor is signally coupled to a warning device.

A system for transfer of electrical energy from a charging plug connector is proposed, which is configured for providing electrical energy, to a corresponding connecting device, including a charging plug connector as described above, with a compressed air connector. Additionally the system includes a connecting device corresponding to the charging plug connector, configured to receive the electrical energy from the charging plug connector. Additionally the system includes a compressed air providing device, for providing compressed air, which is fluid-stream coupled to a compressed air hose and configured to fluid-stream couple with the compressed air connector of the charging plug connector to cool at least a power contact component of the charging plug connector, when electrical energy is transferred.

According to an aspect, the compressed air providing device of the system comprises a cooling device for cooling the compressed air to provide compressed air with a temperature below an ambient temperature of the compressed air providing device. Using the cooling device can enhance the transfer of heat from the power contact component to the compressed air stream to increase a cooling of the system.

### Brief description of the drawings

The accompanying drawings, which are included to provide a further understanding of the invention and are incorporated in and constitute a part of this application, illustrate embodiments of the invention and together with the description serve to explain the principle of the invention. The drawing displays:
- FIG. 1: a cross section of a schema of a charging plug connector;
- FIG. 2: a schematic isometric view of a charging plug connector and a corresponding connecting device;
- FIG. 3: a schematic isometric view of a first connecting region of the charging plug connector mounted within a charging plug connector;
- FIG. 4: a schematic isometric view of a first connecting region of the charging plug connector;
- FIG. 5a: a schematic isometric view of an inside of a charging plug connector with a compressed air stream guiding structure; and
- FIG. 5b: a schematic isometric view of an inside of a charging plug connector.

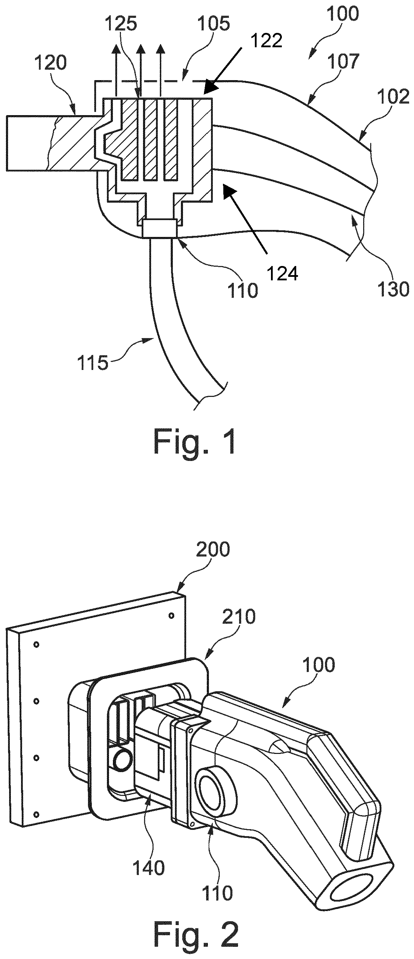

Figure 1 schematically sketches a cross section of a charging plug connector 100 for transfer of electrical energy to a corresponding connecting device. The charging plug connector 100 includes at least one power contact component 122, with a first connecting region 120 for galvanic connection to a corresponding connection region of the connecting device; and a second connecting region 124 electrically coupled to a charging cable 130 for providing of electrical energy to the power contact component 122. The power contact component 122 is configured to provide electrical energy from the charging cable 130 to the first connecting region 120.

The charging plug connector includes a charging plug housing 107, which covers at least the power contact component 122, and a compressed air connector 110, which is mechanically coupled to the charging plug housing 107. The charging plug connector 110 is configured to guide a compressed air stream, which is provided to the compressed air connector 110, particularly by an air hose 115, to the power contact component 122 for cooling it. The charging cable 130 can be covered by an electrical insulation 102. The power contact component 122 can have cooling-holes and/or cooling-channels 125 for increasing a heat transfer from the power contact component 122 to the compressed air stream.

The cooling-holes and/or cooling-channels can be distributed according to the needed cooling, and connected to a distribution device, which is fluidly coupled to a compressed air connector 110. For operation, a compressed air hose 115 can be plugged into this compressed air connector 110.

Figure 2 schematically sketches an isometric view of the charging plug connector 100 and a corresponding connecting device 210, wherein the corresponding connecting device 210 can be mounted within a housing 200 of the electrical vehicle. The charging plug connector 100 includes a compressed air connector 110, which is mechanically mounted and located at the housing of the charging plug connector 100. A part 140 of the charging plug connector 100 covers the first connecting region 120 and is configured to guide the charging plug connector 100 for connecting to the corresponding connecting device 210.

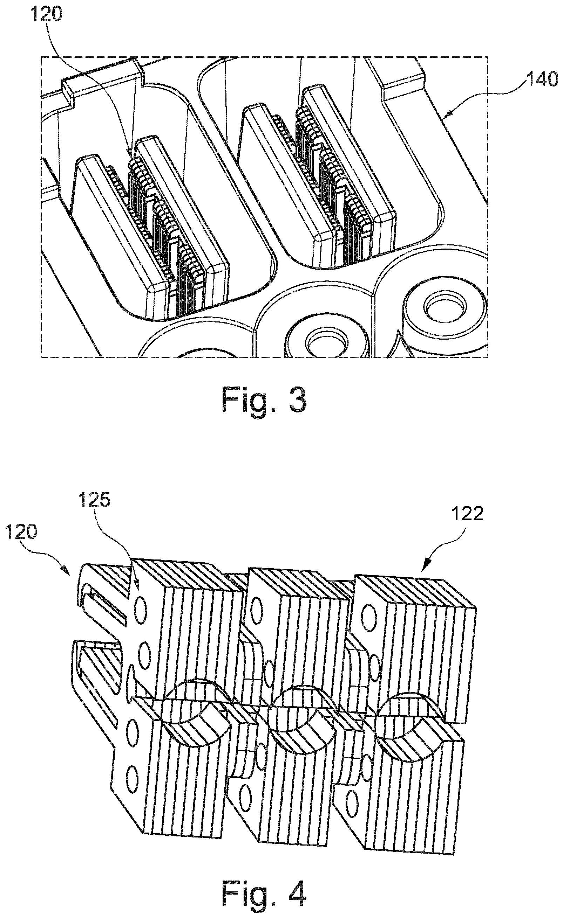

Figure 3 schematically sketches a part of an isometric view of the first connecting region 120, configured as clip springs, of the charging plug connector mounted within the cover of the first connecting region 140 of the charging plug connector. Corresponding connecting regions of the corresponding connecting device, respectively of power contacts, have a flat form. An inlet of the electrical vehicle is provided with male contacts, i.e. flat copper plates, whereas the first connecting region 120 of the charging plug connector, respectively a connector interface, has female contacts, e.g. configured as clip springs.

Both cross sections of the first contacting region 120 and the corresponding connecting region of the connecting device are formed with elongated extension. The corresponding contacting region of the connecting device, respectively a contact element of the vehicle inlet, can be a flat piece of copper. The first connecting region of the charging plug connector, respectively a contact element of the connector, can be formed as a clip spring.

Figure 4 schematically sketches a schematic close-up isometric view of the first connecting region 120 of the charging plug connector being part of the power contact component 122. The power contact component 122 is provided with cooling-holes 125.

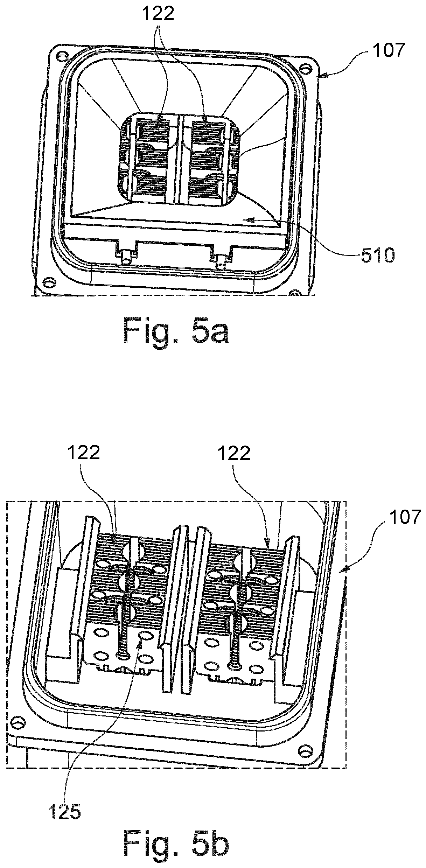

Figure 5a schematically sketches an isometric view of an inside of the housing of charging plug connector 107 with a part of a sub-housing 510, respectively a compressed air stream guiding structure and with the power contact component 122 inside of the housing of the charging plug connector 107. The sub-housing 510 can guide the compressed air stream to the power contact component 122 for cooling.

Figure 5b schematically sketches an isometric view of an inside of the charging plug connector, without the compressed air stream guiding structure 510, but with the power contact component 122 inside of the housing 107 of the charging plug connector 100 for visualization of the cooling-holes 125 inside of the power contact component 122. The complete region including the cooling-holes 125 can be used as air stream path of the compressed air stream for cooling the power contact component 122.

## Claims

1. A charging plug connector (100) for transfer of electrical energy to a corresponding connecting device (210), comprising:
at least one power contact component (122), comprising:
a first connecting region (120) for galvanic connection to a corresponding connection region of the connecting device (210);
a second connecting region (124) electrically coupled to a charging cable (130); wherein the power contact component (122) is configured to provide electrical energy from the charging cable (130) to the first connecting region (120);
a charging plug housing (107) covering the power contact component (122); and
a compressed air connector (110), which is mechanically coupled to the charging plug housing (107), wherein the charging plug connector (100) is configured to guide a compressed air stream, which is provided to the compressed air connector (110), to the power contact component (122) for cooling it.

2. The charging plug connector (100), according to the preceding claims, wherein the first connecting region (120) comprises a clip spring for mechanically and electrically coupling of the first connecting region (120) of the charging plug connector to the corresponding connection region of the connecting device (210) for transfer of electrical energy.

3. The charging plug connector (100), according to the preceding claim, wherein the power contact component (122) comprises cooling-holes (125) for increasing a heat transfer from the power contact component (122) to the compressed air stream.

4. The charging plug connector (100), according to any of the preceding claims, wherein the power contact component (122) comprises cooling-ribs for increasing a heat transfer from the power contact component (122) to the compressed air stream.

5. The charging plug connector (100), according to any of the preceding claims, wherein the power contact component comprises fluid-channels for increasing a heat transfer from the power contact component (122) to the compressed air stream. air cooling channels

6. The charging plug connector (100), according to any of the preceding claims, comprising a distribution device for distributing the compressed air stream provided by the compressed air connector (110) to the cooling-holes (125) and/or calling-ribs and/or fluid-channels of the power contact component (122).

7. The charging plug connector (100), according to any of the preceding claims, wherein the charging plug housing (107) comprises an outlet section (105) for releasing the compressed air stream to an environment of the charging plug connector (100), downstream of the compressed air connector (110).

8. The charging plug connector (100), according to claim 5, wherein the outlet section (105) is configured to release the compressed air stream in a direction away from a handle area of the charging plug connector (100) to increase application safety of the charging plug connector (100).

9. The charging plug connector (100), according to any of the preceding claims, wherein the charging plug housing comprises a sub-housing (510) covering the power contact component (122) inside of the charging plug housing (107), wherein the sub-housing (510) is configured to guide the compressed air stream to the power contact component (122) for increasing the heat transfer from the power contact component (122) to the compressed air stream.

10. The charging plug connector (100), according to any of the preceding claims, wherein the charging plug housing (107) and a housing of the corresponding connecting device is configured, by compressed air stream guiding structures of the charging plug housing (107) and/or by compressed air stream guiding structures of the corresponding connecting device (210), to guide the compressed air stream, provided by the compressed air connector (110), to the corresponding connecting region of the corresponding connection device (210).

11. The charging plug connector (100), according to claim 8, wherein the air stream guiding structures of the charging plug housing (107) and/or the air stream guiding structures of the housing of the corresponding connecting device is configured to release the compressed air stream at the outlet section (105) of the charging plug connector (100).

12. The charging plug connector (100), according to any of the preceding claims, comprising a temperature sensor for determining the temperature of the released compressed air stream at the outlet section (105) of the charging plug connector (100) to increase application safety.

13. A system for transfer of electrical energy from a charging plug connector (100), configured for providing electrical energy, to a corresponding connecting device (210), comprising:
a charging plug connector (100) according to claim 1 to 11, comprising a compressed air connector (110);
a connecting device (210) corresponding to the charging plug connector (100), configured to receive the electrical energy from the charging plug connector (100);
a compressed air providing device, for providing compressed air, which is fluid-stream coupled to a compressed air hose (115) and configured to fluid-stream couple with the compressed air connector (110) of the charging plug connector (100) to cool at least a power contact component (122) of the charging plug connector (100), when electrical energy is transferred.

14. The system according to claim 13, wherein the compressed air providing device comprises a cooling device for cooling the compressed air to provide compressed air with a temperature below an ambient temperature of the compressed air providing device.
